# FASCICULE DE BREVET EUROPEEN

(11) **EP 2 785 164 B1**
(45) Date de publication et mention de la délivrance du brevet: **25.02.2026**
(21) Numéro de dépôt: 14161882.7
(22) Date de dépôt: 27.03.2014
(51) Int. Cl.: H05K 5/02, H05K 5/06

(54) **Baie informatique**
Netzwerkschrank
Computer bay

(30) Priorité: 28.03.2013 FR 1352821
(43) Date de publication de la demande: 01.10.2014
(73) Titulaire: BULL SAS, 78340 Les Clayes-sous-Bois (FR); Commissariat à l'Energie Atomique et aux Energies Alternatives, 75015 Paris (FR)
(72) Inventeur: Bozga, Liana, 38240 MEYLAN (FR); Lachamp, Philippe, 38360 SASSENAGE (FR); Gerphagnon, Jean-Olivier, 38180 SEYSSINS (FR)
(74) Mandataire: Argyma

(56) Documents cités:
- EP-A2- 2 429 272
- DE-A1- 10 210 754
- DE-C1- 10 151 812
- DE-C1- 4 410 795
- DE-U1- 8 714 704
- ES-A1- 2 296 505
- GB-A- 2 212 342
- JP-A- 2003 009 361
- US-A- 5 562 295
- US-A1- 2012 273 438

## Description

L'invention porte sur une baie informatique.

Plus particulièrement, l'invention porte sur une baie informatique comprenant un dispositif de passage de conduit(s) pour permettre un raccordement avec une autre baie informatique. De manière encore plus particulière, l'invention porte sur une baie informatique comprenant un dispositif de passage de conduit(s) pour permettre un raccordement d'équipements disposés dans des baies voisines.

Les baies informatiques, encore dénommées « rack », sont des armoires comprenant deux parois latérales verticales séparant une façade avant d'une façade arrière, et permettant de monter des équipements informatiques et/ou télécoms les uns au-dessus des autres. Les baies informatiques comprennent également un toit afin de protéger les équipements de la poussière. Ces baies existent depuis de nombreuses années et leurs dimensions sont normalisées. Ainsi, les normes internationales CEI (« Commission Electrotechnique Internationale ») 297-2 et -3 datant des années 1982 et 1984 respectivement, et les normes Françaises NFC 20150 et 20151 datant de 1988, définissent des dimensions standards pour les baies informatiques. La largeur de la baie est normalisée à 19 pouces, c'est-à-dire 482,6mm. La hauteur d'un équipement est généralement un multiple d'une longueur dénommée U, pour Unité, normalisée à 1,75 pouces, soit 44,45mm.

Dans un environnement de type salle de réseau, centre de calcul, centre de traitement de données ou supercalculateur par exemple, les baies sont disposées les unes à côté des autres pour former des rangées, chaque rangée étant séparée d'une autre par une allée, de manière à pouvoir accéder aux baies par leurs façades avant et arrière.

La pièce dans laquelle sont disposées les baies est constamment refroidie afin de maintenir une température constante, de l'ordre de 24°C, et d'éviter ainsi une surchauffe des équipements due à la chaleur qu'ils dissipent. Le refroidissement des équipements empilés dans les baies est en effet primordial pour éviter une surchauffe qui pourrait entrainer un défaut de fonctionnement, voir une détérioration irrémédiable d'un équipement. Il faut donc que l'air de refroidissement puisse s'écouler correctement à l'intérieur de chaque baie afin de refroidir chaque équipement. Pour cela, il existe différents systèmes de refroidissement par apport d'air frais. Ces systèmes utilisent le système de climatisation du bâtiment et/ou une porte hydro-réfrigérée disposée à l'arrière de la baie. Les systèmes de refroidissement existants sont plus ou moins performants et plus ou moins couteux. L'utilisation d'un système plutôt qu'un autre dépend en général de la densité de stockage des équipements dans la baie. Quel que soit le système de refroidissement, un flux d'air de refroidissement doit donc circuler dans l'ensemble de la baie afin de refroidir tous les équipements et d'évacuer l'air chaud dissipé par ces équipements. L'air chaud évacué est ensuite refroidi par le système de climatisation existant du bâtiment et/ou par un système de climatisation interne à la baie. Le volume du flux d'air véhiculé au sein de la baie pour refroidir les équipements est préalablement déterminé en fonction du volume de la baie, c'est-à-dire en fonction de sa densité d'occupation par les équipements. Une valeur de consigne de ce volume d'air de refroidissement est donc préétablie. Un système de pilotage permet ensuite de réguler le volume du flux d'air de refroidissement véhiculé au sein de la baie en fonction de la valeur de consigne préalablement établie.

Les équipements empilés dans les baies informatiques sont de diverses natures. Ce peut être des serveurs, des systèmes de stockage, des équipements réseau, etc... Ces équipements sont alimentés en énergie, et sont reliés à d'autres équipements par des câbles.

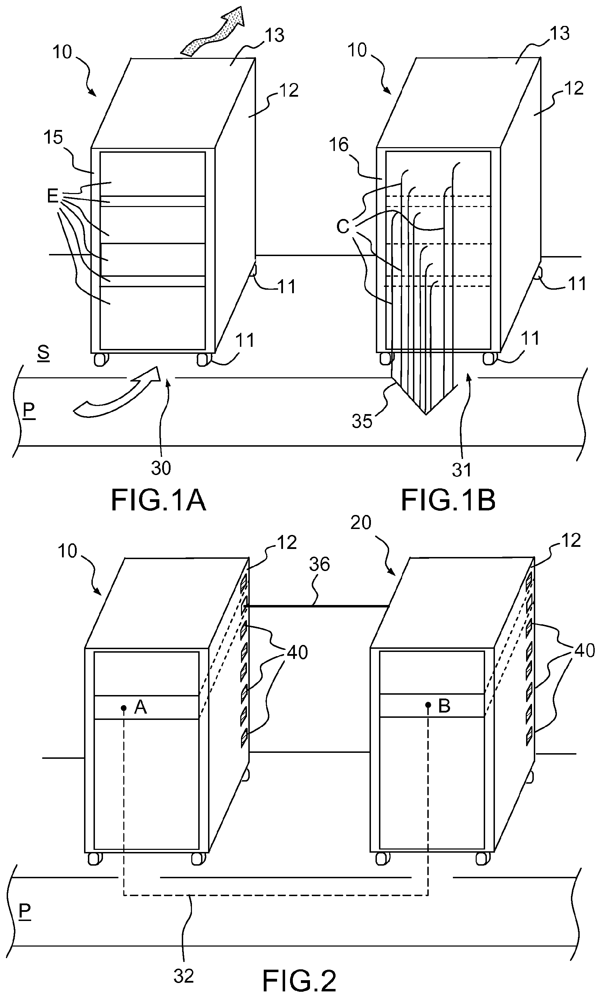

Les Figures 1A et 1B représentent respectivement un schéma en perspective d'une baie 10 vue par sa façade avant 15 et par sa façade arrière 16. Sur la Figure 1A, la baie 10, montée sur des pieds ou roulettes 11, repose sur un sol S et comprend deux parois latérales verticales 12 séparant la façade avant 15 de la façade arrière 16. Un toit 13 permet de protéger de la poussière les équipements E empilés dans la baie 10. Sur le schéma de la Figure 1A, un faux plancher P permet une circulation d'air frais, représenté par une flèche blanche sur la Figure 1A, qui remonte vers la baie à travers une dalle 30 ajourée. De l'air chaud, représenté par une flèche grisée sur la Figure 1A, dissipé par les équipements E, s'évacue par exemple par la façade arrière 16 vers un faux plafond. Plus généralement, l'air chaud est évacué, via une porte perforée ou tout autre moyen équivalent, par extraction, au moyen de ventilateurs par exemple disposés au niveau des équipements. Sur la Figure 1B, la même baie 10 est représentée par sa façade arrière 16. Des câbles C sont connectés aux équipements de la baie, ces câbles sont des câbles d'alimentation en énergie et d'autres câbles sont des câbles de transmission de signaux reliant certains équipements d'une ou plusieurs baies entre - eux. Tous ces câbles C forment un ou plusieurs chemins 35 de câbles qui passent dans le faux plancher P via une ouverture 31. En général un chemin de câble est prévu pour l'alimentation en énergie électrique des équipements, tandis qu'un ou plusieurs autres chemins de câbles sont prévus pour les transmissions de données. Selon les modes de réalisation des salles informatiques, certains chemins de câble peuvent passer par le faux plancher et d'autres par un faux plafond.

L'espace situé sous le plancher permet donc non seulement une circulation d'air frais mais il facilite aussi le câblage d'alimentation en énergie électrique et/ou de données par des chemins de câbles différents. De même, les faux plafonds permettent d'évacuer de l'air chaud, pour son recyclage par un système de climatisation par exemple, et facilitent aussi le câblage d'alimentation en énergie électrique et/ou de données par des chemins de câbles différents. Par conséquent, l'ensemble de la câblerie, permettant de relier les équipements des baies informatiques, passe par un faux plancher et/ou par un faux plafond. Le document ES 2 296 505 décrit la possibilité d'intégrer plusieurs boites de jonction dans un trou pratiqué dans un faux-plancher. Les boites de jonction sont bien fixées au sol, elles prennent moins de place au sol que si elles étaient chacune disposées dans un trou, et elles offrent ainsi plus de connectiques disponibles pour connecter un plus grand nombre d'ordinateurs. De telles boites de jonction, permettant d'augmenter la connectique disponible, contribuent donc à la densification des chemins de câbles situés dans les faux planchers.

Ces zones particulières situées dans les faux plafonds et/ou dans les faux planchers sont donc particulièrement denses en câbles. Or, cette densité de câbles dans ces zones prévues également pour permettre une circulation d'air, peut être préjudiciable au bon écoulement du flux d'air. De plus, dès lors que l'on rajoute un équipement ou même une baie supplémentaire, il faut raccorder le ou les équipements et rajouter des câbles supplémentaires dans les chemins 35 de câbles existants et déjà denses. Or, ce travail est long, délicat et de plus, il n'est pas toujours facile d'y insérer un câble supplémentaire permettant de raccorder un équipement A d'une baie à un équipement B d'une baie voisine par exemple. En effet, dans ce cas, l'opérateur chargé de réaliser les raccordements va essayer d'insérer le câble en force dans le chemin 35 de câbles, en tirant sur le câble par exemple. Une telle insertion en force peut entrainer une détérioration du câble. De plus, cette solution de câblage, illustrée par le câble référencé 32 en traits pointillés sur le schéma de la Figure 2, n'est pas économique. En effet, la longueur des câbles doit prendre en compte la « descente jusqu'au faux plancher P ou la « montée » jusqu'au faux plafond, depuis un équipement d'origine A, et inversement jusqu'à l'équipement de destination B. Par conséquent, pour raccorder deux équipements A et B disposés sur deux baies informatiques 10, 20 adjacentes, la longueur de câble 32 est égale à la somme de la distance entre l'équipement d'origine A jusqu'à la sortie haute ou basse de la baie 10 dans laquelle il est installé, la distance de passage dans le faux plancher P ou dans le faux plafond entre les deux baies 10 et 20, et enfin la distance pour redescendre ou remonter jusqu'à l'équipement destinataire B installé dans la baie 20 voisine.

Outre le fait qu'il est difficile de rajouter des câbles dans des chemins 35 de câblage déjà très denses, un tel câblage reste très coûteux du fait des longueurs de câble utilisées pour raccorder deux équipements. De plus, une telle longueur de câble implique aussi une atténuation du signal qui peut être préjudiciable au bon fonctionnement des équipements. Pour pallier l'atténuation de signal, on utilise en général des câbles de grosse section, donc plus coûteux encore. De plus, parfois il n'existe pas de câbles spécifiques de raccordement de grande longueur. Ainsi, par exemple, pour pouvoir raccorder deux commutateurs réseaux, communément appelés « switch », il est nécessaire de les disposer tous les deux dans une même baie informatique étant donné qu'il n'existe pas de longueur de câble suffisante pour les raccorder lorsqu'ils sont disposés dans deux baies voisines. Le fait d'avoir plusieurs commutateurs réseaux dans une même baie informatique impose ensuite de raccorder un commutateur réseau à un équipement disposé dans une autre baie informatique avec un câble d'une grande longueur et donc très couteux. Il serait donc économiquement et techniquement plus intéressant d'avoir des commutateurs réseaux répartis dans plusieurs baies informatiques.

L'invention a donc pour but de remédier à au moins un des inconvénients de l'art antérieur.

L'invention a notamment pour but de proposer un moyen complémentaire pour le raccordement d'équipements distants, montés sur des baies informatiques voisines, qui permette de faire des économies substantielles en termes de coûts de revient, et qui ne perturbe pas le bon fonctionnement des équipements ni la circulation d'air de refroidissement.

Un autre but de l'invention est de proposer un procédé de raccordement d'équipements distants qui soit rapide et facile à mettre en œuvre, sans risque de détérioration du câble de raccordement, et sans risque pour le fonctionnement des équipements.

A cet effet, l'invention a pour objet une baie informatique selon la revendication 1.

Ainsi, la Demanderesse a fait fi de toutes les idées préconçues en pratiquant au moins une ouverture dans les parois latérales d'une baie pour prévoir un passage de conduits, ou câbles de raccordement. Il n'était pas concevable, jusqu'à présent, de pratiquer de telles ouvertures dans le corps d'une baie informatique. Il est en effet admis depuis que les baies informatiques existent, que le fait de pratiquer des ouvertures dans leurs parois latérales a pour conséquence de créer un échange de flux d'air entre les baies informatiques adjacentes. Un tel échange engendre donc une perte d'air de refroidissement. Or, les flux d'air de refroidissement sont calculés pour le volume de chaque baie, en fonction de leur taux de remplissage. Si les flux d'air passent d'une baie à une autre, ou d'une baie à la pièce, il y a un risque que l'air frais n'atteigne jamais certains équipements, notamment les équipements disposés en haut ou en bas d'une baie. Par conséquent il y a un risque que certains équipements, n'étant pas refroidis ou étant mal refroidis, surchauffent et se détériorent très vite. C'est pourquoi, du fait de la perturbation qu'elles risquent d'engendrer sur le flux d'air, la création de telles ouvertures n'a jamais été envisagée.

De manière avantageuse, le dispositif de passage de conduit, faisant partie intégrante de l'ouverture, permet non seulement de maintenir le(s) conduits(s), ou câble(s), en place, mais aussi de limiter suffisamment les échanges de flux d'air, de sorte que les pertes de refroidissement sont suffisamment négligeables et qu'il n'y a pas de surchauffe notable des équipements.

Grâce à la réalisation de telles ouvertures sur les parois latérales des baies informatiques, il est possible de raccorder très rapidement deux équipements disposés dans deux baies informatiques adjacentes, avec un câble dont la longueur est juste égale à la distance entre les deux équipements, sans perturber les flux d'air de refroidissement circulant au sein des deux baies informatiques. Un tel raccordement ne risque pas de détériorer le câble de raccordement. La longueur du câble de raccordement étant beaucoup plus courte qu'auparavant, cette solution permet de faire des économies substantielles sur le coût de raccordement, et de véhiculer un signal de bonne qualité, non atténué.

Un autre objet de l'invention concerne une salle informatique comprenant une pluralité de baies informatiques disposées les unes à côtés des autres pour former des rangées, chaque rangée étant séparée d'une autre par une allée pour permettre un accès à chaque baie par sa façade avant et sa façade arrière, ladite salle informatique étant caractérisée en ce qu'elle comprend des baies conformes à la baie informatique telle que décrite ci-dessus.

Un autre objet de l'invention se rapporte à un procédé de raccordement de deux équipements montés dans deux baies informatiques adjacentes, caractérisé en ce qu'il consiste à faire passer un conduit à travers deux dispositifs de passage de conduit équipant chacun une ouverture pratiquée dans les parois latérales en vis-à-vis de chacune des baies informatiques, puis à raccorder les deux extrémités du conduit aux deux équipements à raccorder.

L'invention a enfin pour objet un dispositif de passage de conduit(s) pour une baie informatique telle que décrite ci-dessus.

Les dispositifs de passages de câbles sont connus en soit. Le document GB 2 212 342 décrit par exemple un dispositif de passage de câbles comprenant une membrane souple pourvue d'un trou de passage de câble. L'orifice forme un joint d'étanchéité autour du câble et évite ainsi le passage de poussière ou d'humidité. Le document JP2003 009361 décrit un dispositif de passage de câble étanche à l'eau et à l'humidité pour un boitier électrique. Le document US5 562 295 décrit en outre un dispositif hermétique de passage de câble formé par une enveloppe enroulée autour d'un ou plusieurs câbles et qui peut être gonflée d'air afin d'obtenir un joint entre le câble et le conduit dans lequel est introduit le câble. Le document DE 101 51 812 décrit un dispositif de passage de câble souple, dans lequel la membrane souple est remplacée par des poils de brosse de longueurs différentes. En revanche, le fait de disposer de tels dispositifs dans au moins une ouverture pratiquée dans au moins une paroi latérale d'une baie informatique, afin de permettre un passage de conduit tout en évitant un échange de flux d'air avec l'extérieur de la baie, n'est pas décrit et encore moins suggéré dans ces documents.

Le document EP2 429 272 décrit quant à lui une enceinte pour équipement électronique, dans au moins un panneau de laquelle sont prévues des prédécoupes, chaque prédécoupe pouvant être enlevée afin de ménager une ouverture pour le passage d'un câble de raccordement. Ce document décrit donc une manière d'augmenter le nombre potentiel d'entrée / sorties sur l'enceinte d'un équipement, afin de prévoir une augmentation des raccordements de l'enceinte. Ce document ne concerne pas une baie informatique et ne répond pas du tout à la problématique de raccordement d'équipements distants montés sur des baies informatiques voisines, qui permette de faire des économies et qui ne perturbe pas le bon fonctionnement des équipements ni la circulation d'air de refroidissement. Le document US-A-2012273438 décrit une baie informatique équipée d'ouvertures et d'un système de gestion de câbles.

D'autres avantages et caractéristiques de l'invention apparaitront à la lecture de la description suivante donnée à titre d'exemple illustratif et non limitatif, en référence aux Figures annexées qui représentent :
- Les Figures 1A et 1B, déjà décrites, un schéma d'une baie informatique vue respectivement par sa façade avant et par sa façade arrière,
- La Figure 2, un schéma de raccordement de deux équipements montés sur deux baies informatiques adjacentes, le schéma représentant un raccordement classique et un raccordement selon l'invention,
- Les Figures 3A, 3B et 3C, des schémas de face et en coupe d'une ouverture de baie informatique équipée d'un dispositif de passage de conduit selon l'invention,
- Les Figures 4A et 4B, un schéma vue de face et un schéma en coupe d'une ouverture de baie informatique équipée d'un dispositif de passage de conduit selon un exemple comparatif,
- Les Figures 5A et 5B, des schémas en coupe d'une ouverture de baie informatique équipée d'un dispositif de passage de conduit selon un autre exemple comparatif.

Des références identiques sont utilisées sur les Figures pour désigner des éléments identiques ou analogues.

Dans la suite de la description, les termes « parois latérales verticales » s'entendent par rapport à l'axe vertical de la baie lorsque celle-ci est installée dans une pièce. Les termes « bord arrière d'une paroi latérale » définissent le bord d'une paroi latérale situé du côté de la façade arrière d'une baie informatique.

Le terme « conduit » tel qu'utilisé, se rapporte aux câbles d'alimentation électrique, aux câbles de transmission de données, aux conduits de liquide de refroidissement et aussi aux gaines.

La Figure 2 schématise deux baies informatiques adjacentes, référencées respectivement 10 et 20, dans lesquelles sont montés respectivement un équipement A et un équipement B à raccorder. Selon le schéma classique de raccordement, ces deux équipements sont connectés entre eux au moyen d'un câble 32, représenté en traits pointillés sur la Figure 2, partant de l'équipement A vers la sortie basse de la baie 10, passant par le faux plancher P, puis remontant dans la baie 20 vers l'équipement B.

Selon l'invention, les baies informatiques 10 et 20 sont avantageusement pourvues d'ouvertures 40 réparties le long de leurs parois latérales 12. Ces ouvertures permettent de passer un câble 36 d'une baie informatique 10 à une autre baie informatique adjacente 20, de manière rapide et simple sans risquer de détériorer le câble, afin de raccorder deux équipements A et B. La longueur du câble 36 de raccordement est juste égale à la distance entre les deux équipements A et B à raccorder. Par conséquent, le coût du câble est réduit par rapport aux câbles utilisés jusqu'à présent. Le câble de raccordement étant plus court, les problèmes éventuels d'atténuation de signal n'apparaissent pas. Enfin, l'opérateur connectant les deux équipements peut le faire très rapidement sans avoir à tirer sur le câble pour qu'il s'insère dans un chemin de câble très dense au risque de le détériorer. De même, ces ouvertures 40 permettent de faire passer des conduits de liquide de refroidissement d'une baie informatique à une autre, afin de réaliser un système de refroidissement partagé entre plusieurs baies informatiques par exemple. Sur le schéma de la Figure 2, les baies comprennent plusieurs ouvertures 40 sur leurs parois latérales. Ces ouvertures 40 sont disposées à intervalles réguliers dont la longueur est par exemple comprise entre 1U et 4U.

Lorsqu'aucun câble ne passe par ces ouvertures 40, elles sont de préférence fermées pour éviter un échange de flux d'air entre les baies informatiques 10, 20 et une perte d'air de refroidissement au sein de chacune de ces baies. Pour cela, soit le dispositif de passage de conduit équipant l'ouverture permet de fermer cette ouverture en l'absence de câble, soit un autre moyen supplémentaire de fermeture est rajouté pour fermer l'ouverture. Ce moyen de fermeture supplémentaire peut par exemple prendre la forme d'une trappe et être monté coulissant ou mobile en rotation autour d'un axe.

En présence de câble(s) de raccordement, un dispositif de passage de conduit(s), équipant l'ouverture 40, permet non seulement de maintenir les câbles en place à travers l'ouverture 40 mais aussi d'éviter, ou au moins de réduire significativement, des échanges de flux d'air entre deux baies informatiques adjacentes et/ou entre une baie informatique et la pièce dans laquelle elle est installée.

De préférence, les ouvertures 40 sont pratiquées sur la paroi latérale 12 de sorte qu'elles sont situées à proximité du bord arrière de la paroi latérale. Elles sont par exemple réalisées à une distance comprise entre 2 et 15 cm, de préférence entre 2 et 10 cm du bord arrière de la paroi latérale. Cet espace à l'arrière de la baie informatique n'est en général pas occupé par les équipements mais réservé aux passages des câbles. Par conséquent, une ouverture 40 disposée à une telle distance du bord arrière de la paroi latérale 12 de la baie informatique ne risque pas d'être obturée par un équipement.

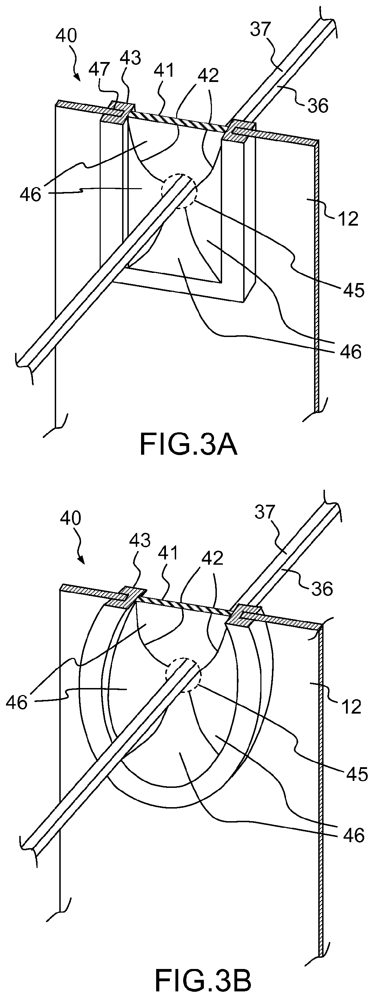

Les Figures 3A à 3C schématisent un dispositif de passage de conduit selon un mode de réalisation. Ce dispositif se présente sous la forme d'une membrane souple 41, par exemple une membrane en caoutchouc. Cette membrane comprend à sa périphérie, un bourrelet 43 comprenant une rainure 47 qui peut s'enchâsser sur les bords périphériques de l'ouverture 40 pratiquée dans la paroi latérale 12 de la baie informatique. La membrane souple 41 est en outre avantageusement prédécoupée, de sorte que la membrane 41 est divisée en plusieurs parties 46, c'est-à-dire au moins deux parties 46. La prédécoupe 42 présente par exemple une forme de croix divisant la membrane en quatre parties 46 aptes à s'écarter et à former un orifice 45 lors de l'introduction d'un câble 36, 37. Les parties 46 prédécoupées de la membrane 41 peuvent s'écarter plus ou moins en fonction de la grosseur et/ou du nombre de câble(s) que l'on insère par l'orifice 45.

Sur l'exemple de la Figure 3A une telle membrane 41 est traversée par deux câbles 36, 37. Les câbles passent par l'orifice 45 créé par l'écartement des parties 46 prédécoupées. La membrane étant souple, elle est élastique et les parties 46 prédécoupées se resserrent sur les câbles 36, 37. La membrane 41 permet donc non seulement de maintenir les câbles 36, 37 en place, mais aussi d'éviter toute perte de flux d'air de refroidissement.

Lorsqu'aucun câble n'est inséré au travers de la membrane 41, les parties 46 prédécoupées ne sont pas écartées, si bien que l'orifice 45 est fermé. La membrane permet donc de fermer l'ouverture 40 en l'absence de câble et d'empêcher toute perte de flux d'air de refroidissement.

La Figure 3B illustre la même membrane de forme circulaire pour s'adapter sur une ouverture circulaire. Les ouvertures 40 pratiquées dans les parois latérales des baies informatiques peuvent en effet être de forme arrondie, de préférence circulaire, ou de forme rectangulaire, de préférence carrée, ou de toute autre forme.

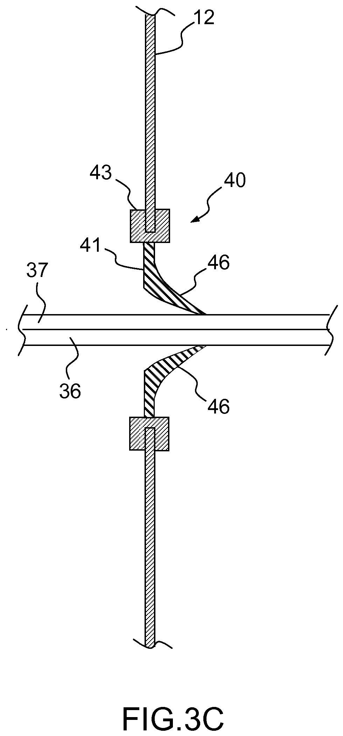

La Figure 3C illustre cette même membrane 41 vue en coupe, intégrée dans l'ouverture 40 d'une paroi latérale 12 de baie informatique. Les parties souples 46 prédécoupées de la membrane 41 s'écartent au passage des câbles 36, 37 et se resserrent sur eux.

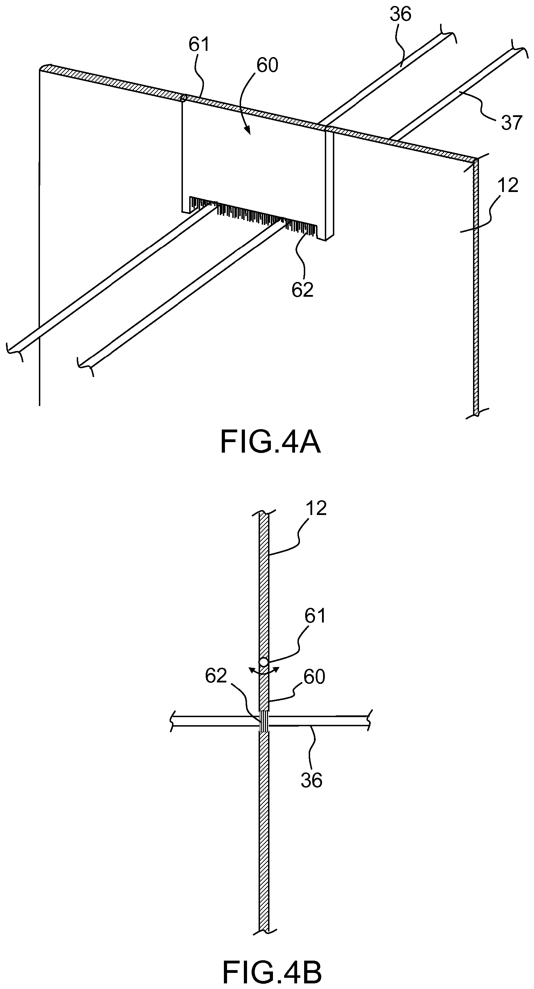

Les Figures 4A et 4B illustrent un autre dispositif de passage de conduit selon une variante non revendiquée. Dans ce cas, le dispositif peut par exemple comprendre une brosse 62 formée par des fils en plastique souple et très serrés. Ces fils s'écartent lorsque l'on fait passer un câble, puis se resserrent sur le câble. Pour faciliter le travail de l'opérateur lorsqu'il raccorde deux équipements, la brosse 62 peut en outre être montée sur une plaque 60 rigide, mobile en rotation autour d'un axe de rotation 61 par exemple. Cet axe de rotation 61 est par exemple fixé sur le bord supérieur de l'ouverture 40, perpendiculairement à l'axe vertical de la paroi latérale 12. Dans ce cas, la plaque 60 forme une trappe et permet le passage d'une main, le temps de passer un câble pour le raccorder à un équipement. Le raccordement terminé, la plaque revient ensuite à sa position verticale de repos. Dans ce cas, la plaque 60 avec sa brosse 62 intégrée permet de réduire de manière significative l'échange de flux d'air entre deux baies adjacentes. La perte d'air de refroidissement est alors imperceptible et tous les équipements au sein de la baie sont suffisamment refroidis.

Dans une variante de réalisation, l'axe de rotation 61 de la plaque 60 peut être monté parallèlement à l'axe vertical de la paroi latérale 12, le long d'un des bords verticaux de l'ouverture 40.

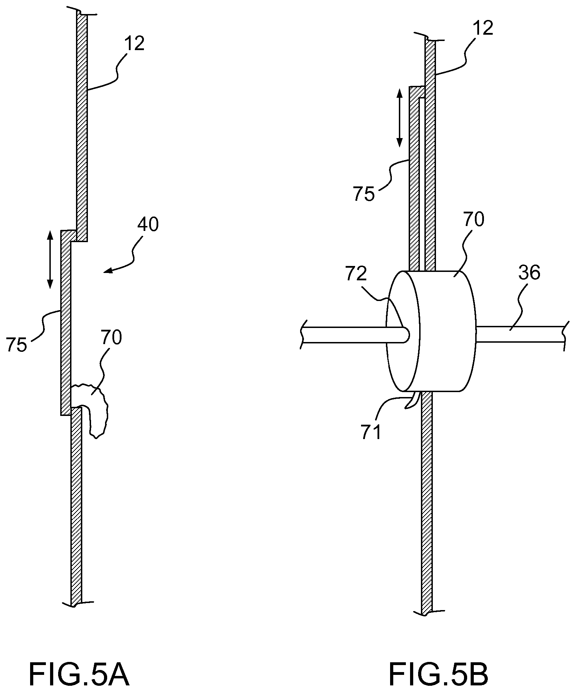

Un autre dispositif de passage de conduit réalisé selon encore une autre variante non revendiquée est schématisé sur les Figures 5A et 5B. Ce dispositif se présente sous la forme d'un manchon 70 gonflable, pourvu d'un orifice 72 en son centre pour permettre le passage d'un ou plusieurs câbles. Lorsque le manchon est dégonflé, tel qu'illustré sur le schéma en coupe de la Figure 5A, l'ouverture 40 n'est pas fermée. Dans ce cas, une trappe 75 est prévue. Cette trappe 75 peut par exemple être montée coulissante le long de la paroi latérale 12 de la baie informatique, en ajoutant des rails de guidage sur la paroi latérale 12 pour permettre un guidage de la trappe lors de son coulissement. On peut aussi prévoir une trappe mobile en rotation autour d'un axe comme pour la plaque 60 de la

Figure 4A. La trappe 75 peut être indifféremment fixée sur la face externe ou interne de la paroi latérale 12 de la baie informatique. De préférence, elle est fixée sur la face interne de la paroi latérale 12, de sorte qu'elle puisse s'ouvrir et se fermer même lorsque la baie informatique et accolée à une autre baie.

Ainsi, lorsqu'aucun câble n'est inséré dans l'ouverture 40, cette-dernière est maintenue fermée grâce à la présence de la trappe 75. Lorsqu'un opérateur veut raccorder deux équipements de deux baies informatiques adjacentes par exemple, il ouvre la trappe 75 en la faisant coulisser, il insère un câble 36 dans l'orifice 72 du manchon 70, puis il gonfle le manchon 70 en raccordant un gonfleur sur une valve 71 du manchon 70. Lorsque le manchon 70 est gonflé, il enserre le câble de sorte qu'aucun flux d'air ne peut passer entre le câble et le manchon, et qu'il maintien en outre fermement le câble. Le manchon gonflé permet également d'obturer l'ouverture 40 et de faire étanchéité au flux d'air, de sorte qu'aucune perte d'air de refroidissement ne peut avoir lieu par cette ouverture 40. Le manchon gonflé permet en outre de maintenir la trappe 75 en position d'ouverture. Selon une variante, pour éviter que le manchon gonflé supporte la trappe 75 et s'abîme sous son poids, la trappe 75 est maintenue en position d'ouverture grâce à un moyen de blocage, tel qu'un loquet par exemple.

Quel que soit le dispositif de passage de conduit utilisé, il permet de faire passer quelques conduits au plus, en général entre 1 et 5 conduits.

Grâce à l'invention, il est possible de raccorder facilement et rapidement des équipements montés sur des baies informatiques adjacentes, sans risque pour le fonctionnement des équipements. Le raccordement ne nécessitant pas de grandes longueurs de câble, il est peu coûteux et permet de conserver un signal de bonne qualité entre les équipements connectés. De même, grâce à l'invention, il est possible de réaliser un système de refroidissement commun à plusieurs baies, en permettant le passage de conduits de liquide de refroidissement d'une baie à une autre par exemple.

## Revendications

1. Baie informatique (10, 20) comprenant une façade arrière (16), une façade avant (15), et deux parois latérales (12) disposées entre les façades avant et arrière, ladite baie étant **caractérisée en ce qu'**au moins une paroi latérale (12) est pourvue d'au moins une ouverture (40) pour permettre un passage de conduit(s), ladite ouverture étant en outre équipée d'un dispositif de passage de conduit (41 ; 60, 62 ; 70, 75) apte à maintenir le(s)dit(s) conduit(s) en place et à obturer ladite ouverture pour éviter un échange de flux d'air de refroidissement avec l'extérieur de la baie, ledit dispositif de passage de conduit est constitué d'une membrane souple (41) prédécoupée, apte à obturer l'ouverture (40), ladite membrane souple (41) comprenant un bourrelet périphérique (43) apte à s'enchâsser sur la bordure périphérique de l'ouverture (40), la membrane souple (41) comprenant une prédécoupe (42) divisant la membrane souple (41) en plusieurs parties (46) aptes à s'écarter et à former un orifice (45) lors de l'introduction d'un conduit (36), les parties (46) étant configurées pour fermer l'orifice (45) en l'absence de conduit et empêcher toute perte de flux d'air de refroidissement, la prédécoupe (42) comprenant des lignes de découpe s'étendant du bourrelet périphérique (43) jusqu'à l'orifice (45).

2. Salle informatique comprenant une pluralité de baies informatiques disposées les unes à côtés des autres pour former des rangées, chaque rangée étant séparée d'une autre par une allée pour permettre un accès à chaque baie par sa façade avant et sa façade arrière, ladite salle informatique étant **caractérisée en ce qu'**elle comprend des baies conformes à la baie informatique selon la revendication 1.

3. Procédé de raccordement de deux équipements (A, B) montés dans deux baies informatiques (10, 20) adjacentes selon la revendication 1, **caractérisé en ce qu'**il consiste à faire passer un conduit (36) à travers deux dispositifs de passage de conduit équipant chacun une ouverture (40) pratiquée dans les parois latérales (12) en vis-à-vis de chacune des baies informatiques (10, 20), puis à raccorder les deux extrémités du conduit aux deux équipements (A, B) à raccorder.

## Patentansprüche

1. Computergehäuse (10, 20) umfassend eine Rückseite (16), eine Vorderseite (15) und zwei Seitenwände (12), die zwischen der Vorder- und der Rückseite angeordnet sind, wobei das Gehäuse **dadurch gekennzeichnet ist, dass** mindestens eine Seitenwand (12) mit mindestens einer Öffnung (40) zum Ermöglichen eines Durchgangs einer Leitung/von Leitungen versehen ist, wobei die Öffnung ferner mit einer Leitungsdurchgangsvorrichtung (41; 60, 62; 70, 75) ausgestattet ist, die geeignet ist, um die Leitung(en) in Position zu halten, und um die Öffnung zu verschließen, zum Vermeiden eines Austausches eines Kühlluftstroms mit dem Äußeren des Gehäuses, wobei Leitungsdurchgangsvorrichtung aus einer vorgeschnittenen, flexiblen Membran (41), die geeignet ist, um die Öffnung (40) zu verschließen, besteht, die flexible Membran (41) umfassend einen umlaufenden Wulst (43) der zum Einbetten in den umlaufenden Rand der Öffnung (40) geeignet ist, die flexible Membran (41) umfassend ein vorgeschnittenes Segment (42), das die flexible Membran (41) in mehrere Teile (46) teilt, die zum Wegrücken und zum Ausbilden eines Lochs (45) während der Einführung einer Leitung (36) geeignet sind, wobei die Teile (46) zum Schließen des Lochs (45) in Abwesenheit der Leitung und zum Verhindern des gesamten Verlusts des Kühlluftstroms geeignet sind, das vorgeschnittene Segment (42) umfassend Schnittlinien, die sich von dem umlaufenden Wulst (43) bis zu dem Loch (45) erstrecken.

2. Computerraum, umfassend eine Vielzahl von Computergehäusen, die nebeneinander zum Ausbilden von Reihen angeordnet sind, wobei jede Reihe von einer anderen durch einen Gang getrennt ist, zum Ermöglichen eines Zugangs zu jedem Gehäuse, über seine Vorderseite und seine Rückseite, wobei der Computerraum **dadurch gekennzeichnet ist, dass** er Gehäuse umfasst, die dem Computergehäuse gemäß Anspruch 1 entsprechen.

3. Verfahren zum Verbinden zweier Geräte (A, B), die in zwei benachbarten Computergehäusen (10, 20) montiert sind, nach Anspruch 1, **dadurch gekennzeichnet, dass** es darin besteht, eine Leitung (36) durch zwei Leitungsdurchgangsvorrichtungen hindurch zu führen, die jeweils mit einer Öffnung (40) ausgestattet sind, die in den Seitenwänden (12) gegenüber jedem der Computergehäuse (10, 20) angebracht sind, dann Verbinden der zwei Enden der Leitung mit den zwei zu verbindenden Geräten (A, B).

## Claims

1. Computer rack (10, 20) comprising a rear face (16), a front face (15), and two side walls (12) which are arranged between the front and rear faces, said rack being **characterised in that** at least one side wall (12) comprises at least one opening (40) to allow duct(s) to pass therethrough, said opening being further equipped with a duct passage device (41; 60, 62; 70, 75) capable of holding said duct(s) in place and closing said opening to prevent an exchange of cooling airflows with the outside of the rack, said duct passage device consisting of a pre-cut flexible diaphragm (41) capable of closing the opening (40), said flexible diaphragm (41) comprising a peripheral bead (43) capable of fitting over the peripheral border of the opening (40), the flexible diaphragm (41) comprising a pre-cut (42) that divides the flexible diaphragm (41) into a plurality of portions (46) which are capable of spreading apart and forming an orifice (45) when a duct (36) is introduced, the portions (46) being designed to close the orifice (45) in the absence of a duct and to prevent any loss of cooling airflows, the pre-cut (42) comprising cutting lines extending from the peripheral bead (43) to the orifice (45).

2. Computer room comprising a plurality of computer racks arranged side by side to form rows, each row being separated from another by means of an aisle to allow access to each rack through its front and rear faces, said computer room being **characterised in that** it comprises racks consistent with the computer rack according to claim 1.

3. Method for connecting two items of equipment (A, B) mounted in two adjacent computer racks (10, 20) according to claim 1, **characterised in that** it consists in passing a duct (36) through two duct passage devices each provided by an opening (40) made in the side walls (12) facing each of the computer racks (10, 20), and then in connecting the two ends of the duct to the two items of equipment (A, B) to be connected.
